# EUROPEAN PATENT APPLICATION

(11) **EP 1 968 108 A1**
(43) Date of publication of application: **10.09.2008**
(21) Application number: 06843456.2
(22) Date of filing: 27.12.2006
(51) Int. Cl.: H01L 21/52, B23K 1/008, B23K 31/02, H01L 21/58, H05K 3/34

(54) **SOLDERING METHOD, SOLDERING APPARATUS AND METHOD FOR MANUFACTURING SEMICONDUCTOR DEVICE**

(30) Priority: 28.12.2005 JP 2005380186
(71) Applicant: KABUSHIKI KAISHA TOYOTA JIDOSHOKKI, Kariya-shi, Aichi 448-8671 (JP)
(72) Inventor: KIMBARA, Masahiko, Kariya-shi Aichi 448-8671 (JP); KUMANO, Akiko, Kariya-shi Aichi 448-8671 (JP); KUBO, Hidehito, Kariya-shi Aichi 448-8671 (JP); TOH, Keiji, Kariya-shi Aichi 448-8671 (JP); SHIRAKI, Masao, Kariya-shi Aichi 448-8671 (JP); HIGASHIMOTO, Shigekazu, Kariya-shi Aichi 448-8671 (JP)
(74) Representative: TBK-Patent
(86) International application number: PCT/JP2006/326074
(87) International publication number: WO 2007/077877

(57) **Abstract**

An object-to-be-soldered (92) is accommodated in a sealable chamber (17). An internal pressure (P) of the chamber (17) is raised to a normal pressure (Po) or higher by feeding a reducing gas to the chamber (17). A soldering of a semiconductor element (12) with respect to a circuit board (11) is carried out in the pressurized state. The pressurized state indicating a set pressure (P1) (for example, 0.13 MPa) is maintained in a solder melting period (t3 to t7) until the molten solder (33) is solidified (t7) after the solder (33) starts melting (t3). Accordingly, voids are inhibited from being generated in the solder after being solidified.

## Description

### TECHNICAL FIELD

The present invention relates to a soldering method of soldering a semiconductor element to a circuit board, a soldering apparatus, and a method for manufacturing semiconductor devices.

### BACKGROUND ART

A conventional semiconductor module includes a ceramic substrate, a wiring layer, which is a metal plate joined to a surface of the ceramic substrate, and a joining layer, which is a metal plate joined to a back surface of the ceramic substrate. A semiconductor element is soldered (joined) to the wiring layer. A heat radiating device, that is, a heat sink for radiating heat generated by the semiconductor element is joined to the joining layer.

At a time of soldering, it is often the case that a void is generated in the solder in the process of solidification of the solder after the solder is molten. In the case that a lot of voids are generated in the solder, resistances of electricity and heat passing through the solder become higher. Further, if the size of one void becomes equal to or more than a certain degree, the electricity and the heat flow through the wiring layer and the circuit board while bypassing the void from the semiconductor element. Accordingly, a hot spot, which is a locally high temperature region, is generated about a void of the semiconductor element. As a result, the semiconductor element can be destroyed.

Accordingly, Patent Document 1 and Patent Document 2 propose a technique of suppressing the void generation. These publications propose a technique of soldering by evacuating a chamber at a time of heating solder so as to depressurize, and melting the solder in a state in which the degree of vacuum is high.

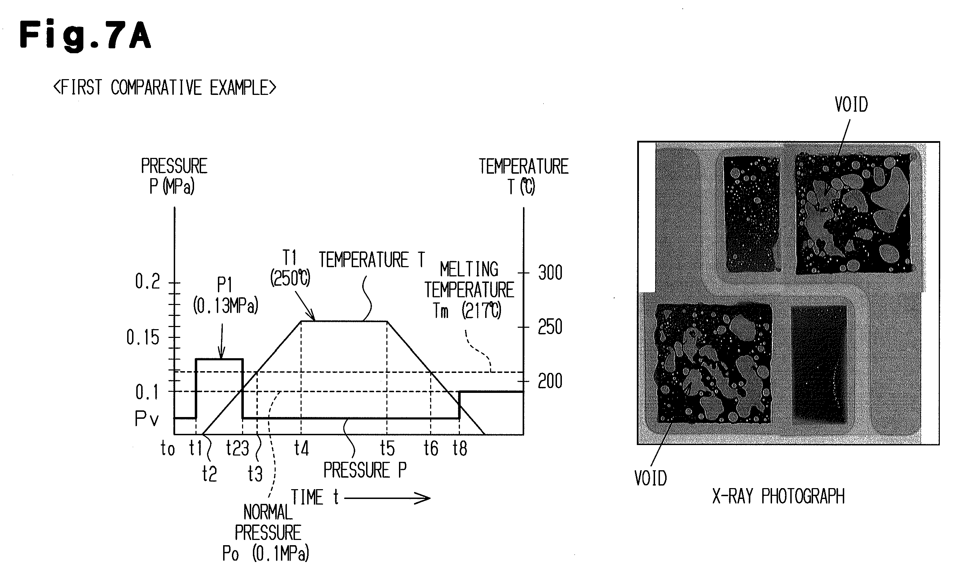

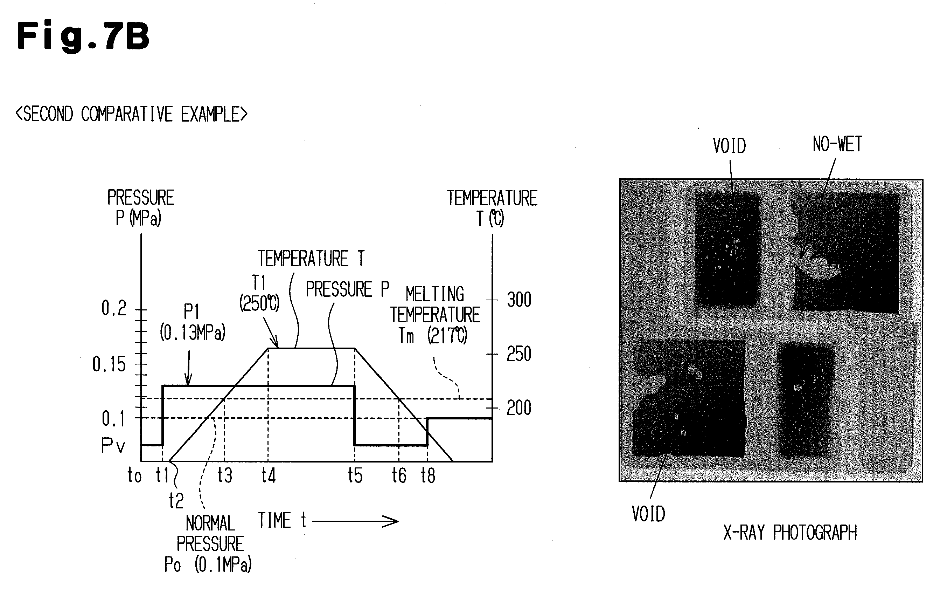

However, as shown in Figs. 7A and 7B, the inventor conducted an experiment and verified the fact that the void is generated even in the case where soldering is carried out by melting solder in a high degree of vacuum. Accordingly, it is hard to say that the soldering method in the publications mentioned above can suppress the generation of voids.
Patent Document 1: Japanese Laid-Open Patent Publication No. 2005-230830
Patent Document 2: Japanese Laid-Open Patent Publication No. 2005-271059

### DISCLOSURE OF THE INVENTION

An objective of the present invention is to provide a soldering method and a soldering apparatus that suppress the generation of voids.

In accordance with one aspect of the present invention, there is provided a soldering method of soldering a semiconductor element to a circuit board. The soldering method includes a step of accommodating an object-to-be-soldered in a chamber. The object-to-be-soldered includes the circuit board, the semiconductor element, and solder arranged between the circuit board and the semiconductor element. The solder has a melting temperature. The soldering method includes a step of achieving a reduction state in which the chamber is filled with an atmospheric gas at least including a reducing gas. The soldering method includes a step of melting the solder by heating the solder in such a manner as to raise a temperature of the solder to the melting temperature or higher, in the chamber in the reduction state. The soldering method includes a step of soldering the semiconductor element to the circuit board by solidifying the solder by lowering the temperature of the molten solder to lower than the melting temperature. The soldering method includes a step of structuring the chamber to be sealable, and a step of raising an internal pressure of the chamber to a melting start pressure equal to or higher than a normal pressure by the atmospheric gas until the rising temperature of the solder reaches the melting temperature. The melting start pressure is the internal pressure of the chamber at the time when the solder starts melting. The soldering method includes a step of achieving a pressurization state in which the internal pressure of the chamber is set to be equal to or higher than the melting start pressure, in a solder melting period. The solder melting period corresponds to a period until the molten solder is solidified after the solder starts melting. The soldering method includes a step of soldering the semiconductor element to the circuit board in the pressurization state.

Further, in accordance with another aspect of the present invention, there is provided a method for manufacturing semiconductor devices including a circuit board and a semiconductor element soldered to the circuit board.

Further, in accordance with another aspect of the present invention, there is provided a soldering apparatus for soldering a semiconductor element to a circuit board. The soldering apparatus includes a sealable chamber. A heating apparatus heats a solder arranged between the circuit board and the semiconductor element so as to melt the solder. The circuit board, the semiconductor element and the solder construct an object-to-be-soldered. The solder has a melting temperature. A gas introduction portion introduces an atmospheric gas at least including a reducing gas to the chamber. The gas introduction portion introduces the atmospheric gas to the chamber in a state in which the object-to-be-soldered is accommodated. The heating apparatus raises a temperature of the solder, to which the atmospheric gas has been introduced, to the melting temperature or higher so as to melt the solder. The gas introduction portion raises an internal pressure of the chamber to a melting start pressure equal to or higher than the normal pressure by the atmospheric gas, until the rising temperature of the solder reaches the melting temperature. The soldering apparatus is structured such as to achieve a pressurization state in which the internal pressure of the chamber is set to a pressure equal to or higher than the melting start pressure, in a solder melting period until the molten solder is solidified after the solder starts melting. The soldering apparatus is structured such as to solder the semiconductor element to the circuit board in the pressurization state.

### BRIEF DESCRIPTION OF THE DRAWINGS

Fig. 1 is a plan view of a semiconductor module manufactured by a manufacturing method in accordance with the present invention;
Fig. 2 is a cross-sectional view taken along line 2-2 in Fig. 1;
Fig. 3 is a vertical cross-sectional view of a soldering apparatus according to the present invention;
Fig. 4(a) is a plan view of the jig shown in Fig. 3;
Fig. 4(b) is a perspective view of the weight shown in Fig. 3;
Fig. 5 is a plan view showing a layout of a high-frequency heating coil with respect to the semiconductor module shown in Fig. 3;
Fig. 6A is a graph showing a transition of a pressure and an X-ray photograph of a manufactured semiconductor module in a first experimental example of the soldering apparatus in Fig. 3;
Fig. 6B is a graph showing a transition of a pressure and an X-ray photograph of a manufactured semiconductor module in a second experimental example of the soldering apparatus in Fig. 3;
Fig. 7A is a graph showing a transition of a pressure and an X-ray photograph of a manufactured semiconductor module in a first comparative example;
Fig. 7B is a graph showing a transition of a pressure and an X-ray photograph of a manufactured semiconductor module in a second comparative example; and
Fig. 8 is a graph showing a transition of a pressure in a modified embodiment in accordance with the present invention.

### BEST MODE FOR CARRYING OUT THE INVENTION

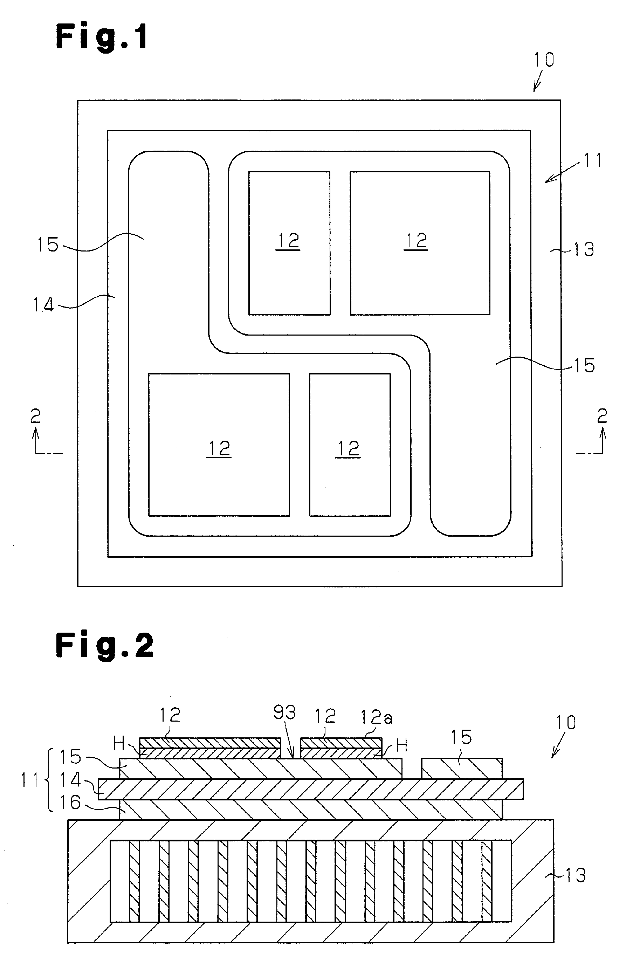

A description will be given below of one embodiment according to the present invention with reference to Figs. 1 to 7B.

As shown in Figs. 1 and 2, a semiconductor module 10, which is a semiconductor device, includes a circuit board 11, semiconductor elements 12 joined to the circuit board 11, and a heat sink 13, which is a heat radiating device. The circuit board 11 includes a ceramic substrate 14, wiring layers 15 joined to a surface of the ceramic substrate 14, that is, a top surface in Fig. 2, and a bonding layer 16 joined to a back surface of the ceramic substrate 14, that is, a lower surface in Fig. 2. The ceramic substrate 14 is formed, for example, by aluminum nitride, alumina, or silicon nitride. The wiring layers 15 are formed, for example, by aluminum (pure aluminum and an aluminum alloy) or copper. The semiconductor elements 12 are soldered to the wiring layers 15. Solder layers H are positioned between the semiconductor elements 12 and the wiring layer 15. The semiconductor elements 12 and the wiring layers 15 correspond to a joining member to which the solder is joined.

The semiconductor elements 12 include an insulated gate bipolar transistor (IGBT) or a diode. A plurality of, four in the present embodiment, semiconductor elements 12 are joined to the circuit board 11. The bonding layer 16 joins the heat sink 13 to the ceramic substrate 14. The bonding layer 16 is formed, for example, by aluminum or a copper. The heat sink 13 is joined to the bonding layer 16.

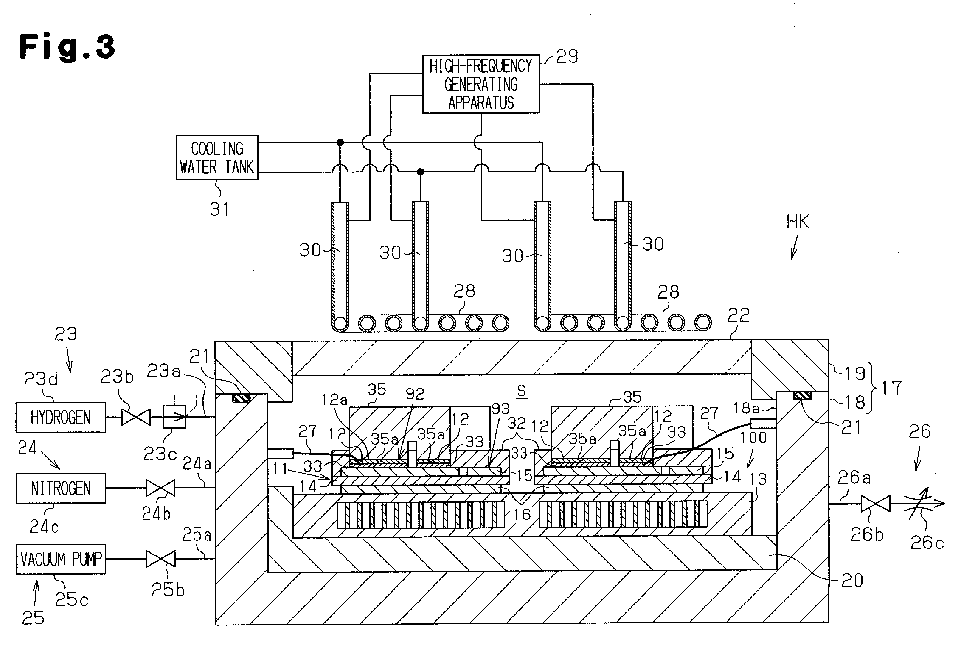

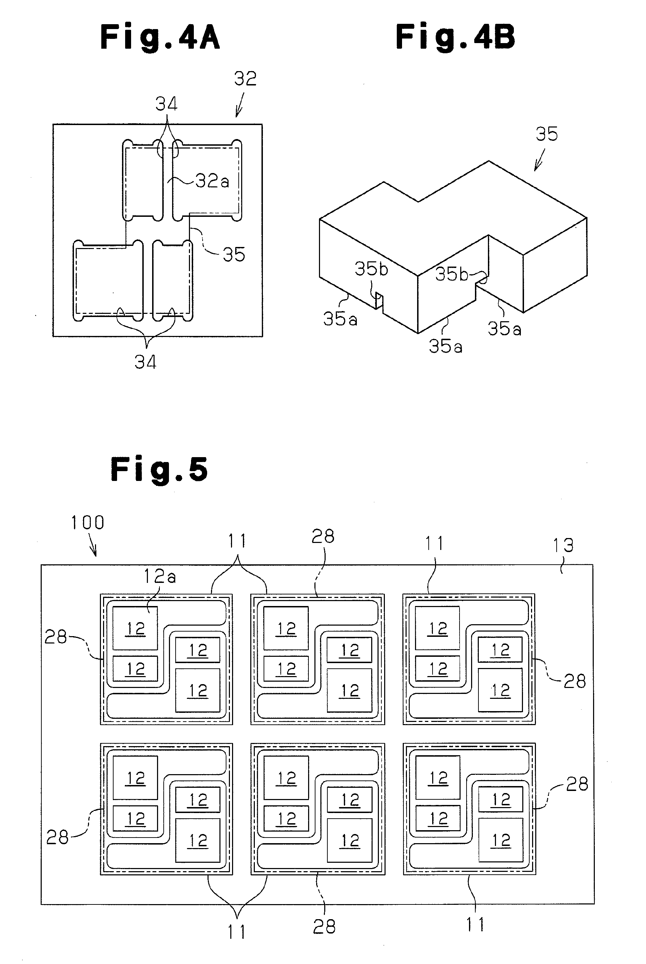

As shown in Fig. 3, a soldering apparatus HK solders the semiconductor elements 12 to the circuit board 11. Fig. 5 shows a large-scaled semiconductor module 100 corresponding to six semiconductor modules 10 in Fig. 1. In other words, the semiconductor module 100, which is the semiconductor device, includes six circuit boards 11, and twenty four semiconductor elements 12. The soldering apparatus HK manufactures the semiconductor module 100.

As shown in Fig. 3, the soldering apparatus HK is provided with a sealable chamber 17. The chamber 17 includes a box main body 18 having an opening 18a, and a lid 19 which can switch an open state and a closed state of the opening 18a. A support table 20 for positioning and supporting the semiconductor module 100 is accommodated in the box main body 18. A gasket 21 is arranged at an attaching position of the lid 19 in the box main body 18.

The lid 19 has a size which can close the opening 18a of the box main body 18. The box main body 18 and the lid 19 define a sealed space S within the chamber 17. The lid 19 includes a glass plate 22 opposing to the sealed space S. The glass plate 22 serves as a nonmagnetic and electrically insulating material.

As shown in Fig. 3, a reducing gas feeding portion 23 serving as a gas introduction portion feeding a reducing gas to the chamber 17 is connected to the box main body 18. In the present embodiment, the reducing gas is hydrogen gas (H₂). The reducing gas feeding portion 23 is provided with a piping 23a, an on-off valve 23b of the piping 23a, a pressure reducing valve 23c, which is a first pressure regulating portion, and a hydrogen tank 23d. The pressure reducing valve 23c feeds hydrogen gas introduced from the hydrogen tank 23d while passing through the on-off valve 23b to the chamber 17 while setting the pressure to a fixed value.

Inert gas feeding portion 24 for feeding an inert gas to the chamber 17 is connected to the box main body 18. In the present embodiment, the inert gas is nitrogen gas (N₂). The inert gas feeding portion 24 is provided with a piping 24a, an on-off valve 24b of the piping 24a, and a nitrogen tank 24c. Further, a vacuum portion 25 for evacuating the inside of the chamber 17 is connected to the box main body 18. The vacuum portion 25 is provided with a piping 25a, an on-off valve 25b of the piping 25a, and a vacuum pump 25c.

Further, a gas discharge portion 26 for discharging gas filling the chamber 17 to an outside is connected to the box main body 18. The gas discharge portion 26 is provided with a piping 26a, an on-off valve 26b of the piping 26a, and a throttle valve 26c, which is a second pressure regulating portion. The gas within the chamber 17 is discharged to the outside while being regulated in the discharging amount by the throttle valve 26c. The soldering apparatus HK is structured such as to be capable of regulating the pressure in the sealed space S by being provided with the reducing gas feeding portion 23, the inert gas feeding portion 24, the vacuum portion 25 and the gas discharge portion 26. In other words, the soldering apparatus HK pressurizes or depressurizes the sealed space S on the basis of pressure regulation.

A temperature sensor 27 measuring the temperature T within the chamber 17 is arranged in the box main body 18. The temperature sensor 27 is, for example, a thermo couple. In the present embodiment, the temperature sensor 27 is arranged in such a manner as to be capable of measuring the temperature T at a joining section of a semiconductor element 12 to a wiring layer 15, that is, a section which is soldered.

A plurality of high-frequency heating coils 28 serving as a heating device are located in an upper portion of the soldering apparatus HK, that is, above the lid 19. Six high-frequency heating coils 28 are arranged over the circuit boards 11 in such a manner as to individually correspond to six circuit boards 11 shown in Fig. 5. Each of the high-frequency heating coils 28 has such a size as to expand over one circuit board 11. Further, each of the high-frequency heating coils 28 is formed larger than the outline of the upper surface of the weight 35.

As shown in Fig. 5, each of the high-frequency heating coils 28 is formed as a spiral shape, particularly a rectangular spiral shape. Each of the high-frequency heating coils 28 is expanded two-dimensionally. Each of the high-frequency heating coils 28 is arranged in such a manner as to oppose to the glass plate 22 of the lid 19. The soldering apparatus HK has a high-frequency generating device 29 to which each of the high-frequency heating coils 28 is electrically connected. Each of the high-frequency heating coils 28 is controlled to a predetermined temperature on the basis of a result of measurement of the temperature sensor 27. A cooling path 30 for putting cooling water through the inside of the coil 28 is formed in each of the high-frequency heating coils 28. The soldering apparatus HK has a cooling water tank 31 to which the cooling path 30 is connected.

Fig. 4(a) shows a jig 32 used for soldering. Fig. 4(b) shows a weight 35 serving as a pressing body. The jig 32 is formed as a flat plate having the same size as the ceramic substrate 14 of the circuit board 11. The jig 32 is made, for example, of graphite or ceramics. As shown in Fig. 3, each jig 32 positions a solder sheet 33, a semiconductor element 12 and a weight 35 on the circuit board 11, at the time of soldering. Each jig 32 has a plurality of positioning through holes 34. Since four semiconductor elements 12 are joined onto the circuit board 11, each jig 32 has four through holes 34. Each of the through holes 34 corresponds to a joined section of the semiconductor elements 12 on the circuit board 11. Each of the through holes 34 has a size corresponding to the semiconductor elements 12. The temperature T measured by the temperature sensor 27 indicates the temperature within the chamber 17 and the temperature of the solder sheet 33.

If a magnetic flux passing through each weight 35 is changed, an electric current is generated in the weight 35. The material of the weight 35 is selected in such a manner that the weight 35 generates heat on the basis of an electric resistance of the weight 35 itself. In the present embodiment, the weight 35 is made of stainless steel. As shown in Fig. 3, the weights 35 are arranged immediately above the semiconductor elements 12 at the time of soldering. In other words, the weights 35 come into contact with upper surfaces, that is, non-joining surfaces 12a of the semiconductor elements 12. As a result, the weights 35 press the semiconductor elements 12 toward the circuit board 11. Each of the weights 35 is an integrated part produced by machining a material. A pressing surface 35a of the weight 35 can be fitted and inserted to a through hole 34 of the jig 32. The pressing surface 35a of one weight 35 can come into contact with and press a non-joining surface 12a of four semiconductor elements 12. The jig 32 has a partition 32a defining the adjacent through holes 34. The pressing surface 35a has a groove 35b extending over the partition 32a. The pressing surface 35a of the weight 35 serves as a surface which comes into contact with the non-joining surface 12a of each semiconductor element 12. Fig. 4(a) shows a state in which one weight 35 shown by a two-dot chain line enters four through holes 34.

Next, a description will be given of a method by which the soldering apparatus HK solders the semiconductor elements 12 to the circuit board 11. As shown in Fig. 3, there is previously prepared a joined object 93 including the circuit board 11, and the heat sink 13 joined to the circuit board 11.

At a time of carrying out the soldering, first, the lid 19 is detached from the box main body 18, and the opening 18a is opened. As shown in Fig. 3, the joined object 93 is arranged on the support table 20 of the box main body 18 while being positioned. Next, the jig 32 is set on the circuit boards 11. The solder sheets 33 and the semiconductor elements 12 are arranged within each of the through holes 34 of the jig 32 in this order. The weights 35 are set onto the semiconductor elements 12. In other words, the solder sheets 33, the semiconductor elements 12, and the weights 35 are laminated on the wiring layers 15 in this order. The solder sheets 33, the semiconductor elements 12, and the weights 35 are laminated in a vertical direction of the soldering apparatus HK. In other words, the solder sheets 33, the semiconductor elements 12, and the weights 35 are laminated toward the lid 19. The joined object 93 is arranged horizontally with respect to a ground surface. The pressing surface 35a of each weight 35 comes into contact with the non-joining surface 12a of the corresponding semiconductor element 12, and presses the non-joining surface 12a.

As mentioned above, an object-to-be-soldered 92 is arranged within the chamber 17. The object-to-be-soldered 92 includes the joined object 93, the solder sheets 33, and the semiconductor elements 12.

Next, the opening 18a is closed by attaching the lid 19 to the box main body 18, and a sealed space S is defined within the chamber 17. As shown in Fig. 3, in a state in which the object-to-be-soldered 92 is accommodated in the sealed space S, each of the high-frequency heating coils 28 is arranged above each of the weights 35. The glass plate 22 is arranged between the high-frequency heating coils 28 and the weights 35. In a state in which the high-frequency heating coils 28 are arranged above the weights 35, each high-frequency heating coil 28 lies off the outline of the upper surfaces of the corresponding weights 35. Since each high-frequency heating coil 28 is formed as the spiral shape, a lot of magnetic fluxes are generated in an area close to the center. Accordingly, it is preferable to arrange each weight 35 and the joined section to the circuit board 11 in such a manner as to correspond to the center of the high-frequency heating coil 28. The joined section of the circuit board 11 refers to a section at which the semiconductor elements 12 are joined.

Next, the gas within the chamber 17 is replaced. First, the inside of the chamber 17 is evacuated by operating the vacuum portion 25. Nitrogen gas is fed into the chamber 17 by operating the inert gas feeding portion 24. In other words, the sealed space S is filled with inert gas. Hydrogen gas is fed into the chamber 17 by repeating the evacuation and the feed of the nitrogen gas several times, and thereafter operating the reducing gas feeding portion 23. In other words, the inside of the chamber 17 is set to a reducing gas atmosphere.

Next, a high-frequency current is circulated to each of the high-frequency heating coils 28 by actuating the high-frequency generating device 29. Then, there is generated a high-frequency magnetic flux passing through each weight 35. An eddy current is generated in the weight 35. In other words, the weight 35 exposed to the magnetic flux generated by the high-frequency heating coil 28 generates heat on the basis of an electromagnetic induction effect. The heat of the weight 35 is transmitted to the corresponding semiconductor element 12 from the pressing surface 35a. As a result, the heat of the weight 35 is intensively, that is, locally transmitted to the joined section with the solder sheet 33 in the circuit board 11. As a result, the temperature T of the solder sheet 33 becomes equal to or higher than a melting temperature Tm, and the solder sheet 33 melts. The semiconductor elements 12 are pressed toward the circuit board 11 by the weight 35. Accordingly, the semiconductor elements 12 are prevented from being lifted up or being moved by a surface tension of the melting solder.

If the solder sheets 33 completely melt, the high-frequency generating device 29 is stopped. The solder is cooled until the melting solder is solidified. The melting solder is solidified by being cooled to the temperature lower than the melting temperature Tm, and joins the semiconductor elements 12 to the wiring layers 15. If the semiconductor elements 12 are joined to the wiring layers 15, the semiconductor module 100 is finished. Thereafter, the lid 19 is taken out from the box main body 18, the jigs 32 and the weights 35 are detached, and the semiconductor module 100 is taken out from the inside of the chamber 17. At a time of taking out the semiconductor module 100 from the chamber 17, the gas discharge portion 26 releases the gas within the chamber 17 to the atmospheric air.

The internal pressure P of the chamber 17 is raised and lowered on the basis of the measured temperature of the temperature sensor 27 and an elapse of a time. Since the reducing gas feeding portion 23, the inert gas feeding portion 24, the vacuum portion 25, and the gas discharge portion 26 feed gas into the chamber 17 or discharge gas from the inside of the chamber 17, the internal pressure P of the chamber 17 is raised or lowered. The pressure reducing valve 23c of the reducing gas feeding portion 23, and the throttle valve 26c of the gas discharge portion 26 circulate the reducing gas to the inside of the chamber 17 at a time of heating and cooling the solder.

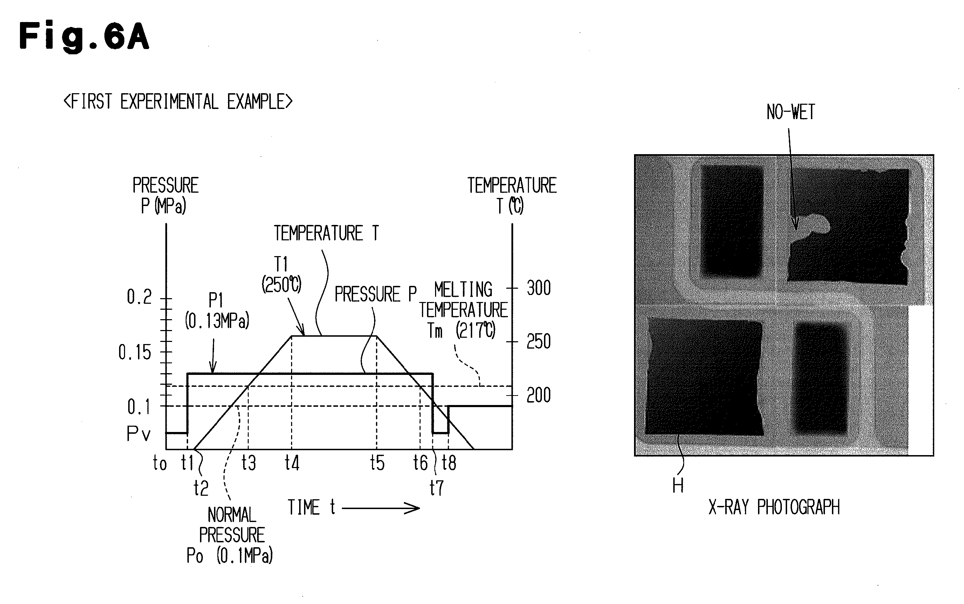

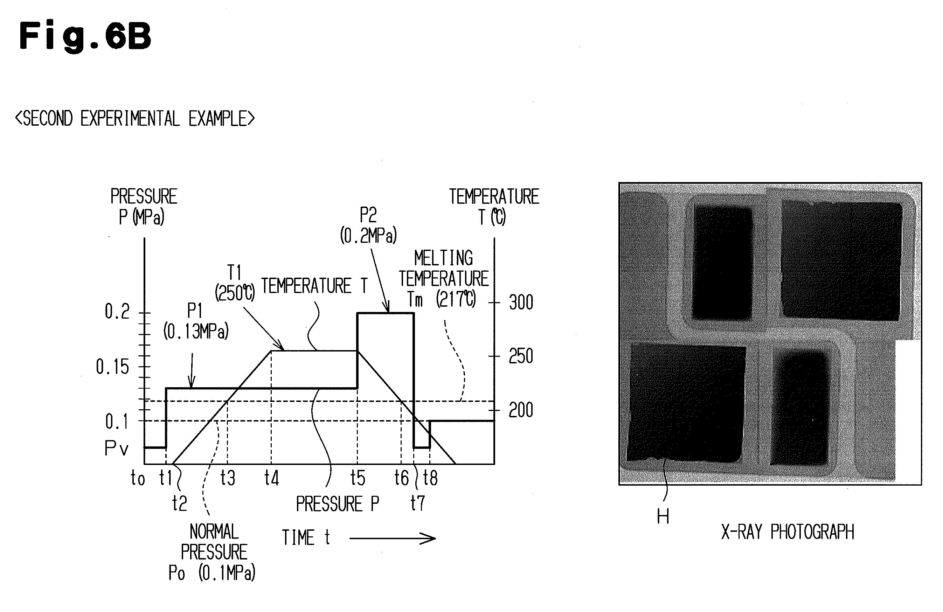

A description will be given of a manner of regulating the atmospheric air within the chamber 17 at a time of heating and cooling the solder, in a first experimental example shown in Fig. 6A, and a second experimental example shown in Fig. 6B.

Dimensions of each of the semiconductor modules 10 used in the first experimental example and the second experimental example were as follows.

The ceramic substrate 14 was made of aluminum nitride. The ceramic substrate 14 was a quadrangular plate of 30 mm × 30 mm having a thickness 0.635 mm. Each of the wiring layer 15 and the bonding layer 16 was made of pure aluminum, for example, 1000 series aluminum, which is an industrial pure aluminum. Each of the wiring layer 15 and the bonding layer 16 was a rectangular plate of 27 mm × 27 mm having a thickness 0.4 mm. The thickness of the semiconductor elements 12 was 0.35 mm. The solder sheet 33 was made of a Sn-Cu-Ni-P based lead-free solder. The thickness of the solder sheet 33 was between 0.1 mm and 0.2 mm.

First, as shown by a graph in Fig. 6A, a description will be given of a transition, that is, a regulation of the internal pressure P of the chamber 17 in the first experimental example.

Since the chamber 17 was evacuated, the internal pressure P of the chamber 17 at an initial time "to" indicated a state having a high degree of vacuum. The ambient atmosphere in the chamber 17 was replaced by a reducing gas atmosphere having a set pressure P1 which was higher than a normal pressure Po, at a first point in time t1. In the present specification, the normal pressure Po, that is, the atmospheric pressure was about 0.1023 MPa. The set pressure P1 was 0.13 MPa. The set pressure P1 was the internal pressure of the chamber 17 at a time when the solder sheet 33 starts melting, that is, a melting start pressure.

Heating of the solder sheet 33 was started at a second point in time t2 after the first point in time t1. In other words, the ambient atmosphere in the chamber 17 was replaced by reducing gas atmosphere having the set pressure P1 before the second point in time t2 at which the heating of the solder sheet 33 was started.

The temperature T of the solder sheet 33 reached a melting temperature Tm at a third point in time t3. In other words, the internal pressure P of the chamber 17 was raised to the normal pressure Po or higher at the first point in time t1, before the third point in time t3 at which the temperature T of the solder sheet 33 reached the melting temperature Tm. In the present specification, the melting temperature Tm of the solder sheet 33 is 217 °C.

The solder 33 was heated until the temperature T of the solder sheet 33 reaches a set temperature T1 at a fourth point in time t4. The set temperature T1 was higher than the melting temperature Tm. The set temperature T1 was 250 °C. In other words, the solder sheet 33 was heated between the second point in time t2 and the fourth point in time t4, after the gas replacement of the inside of the chamber 17 at the first point in time t1. The temperature T of the solder sheet 33 was maintained to the set temperature T1 between the fourth point in time t4 and a fifth point in time t5.

The internal pressure P of the chamber 17 was regulated between the first point in time t1 and a seventh point in time t7 in such a manner as to maintain the set pressure P1. In other words, the internal pressure P of the chamber 17 in the first experimental example was maintained at the set pressure P1 without being lowered to the normal pressure Po or lower (vacuum) between the second point in time t2 and the fifth point in time t5 at which the solder sheet 33 was heated. The heating of the solder sheet 33 was finished at the fifth point in time t5. In the first experimental example, the internal pressure P of the chamber 17 was maintained at the set pressure P1 even at a time of cooling the solder between the fifth point in time t5 and the seventh point in time t7. At a sixth point in time t6, the temperature T of the solder was lowered than the melting temperature Tm. When the solder was solidified, the internal pressure P of the chamber 17 was temporarily lowered to the normal pressure Po or less at the point in time t7, whereby the reducing gas was discharged. Thereafter, at an eighth seven point in time t8, the internal pressure P of the chamber 17 was recovered to the normal pressure Po by introducing the atmospheric air to the chamber 17.

An X-ray photograph on the right side of the graph in Fig. 6A shows a back surface, that is, a joining surface of a semiconductor element 12 soldered in the first experimental example. A portion which is deepest in color in the X-ray photograph indicates the solder layer H. In accordance with the X-ray photograph in Fig. 6A, an unwet spot was observed in a part of the solder layer H, however, no voids were observed.

Next, a description will be given of a transition, that is, a regulation of the internal pressure P of the chamber 17 in the second experimental example, as shown in a graph in Fig. 6B.

As shown in Fig. 6B, the internal pressure P of the chamber 17 was regulated in the same manner as the first experimental example in Fig. 6A, between the initial point in time t0 and the fifth point in time t5 of the second experimental example. In other words, in the second experimental example, the internal pressure P of the chamber 17 at a time of heating the solder was maintained at the set pressure P1 (0.13 MPa) which was higher than the normal pressure Po. As shown in Fig. 6B, when the heating of the solder was finished at the fifth point in time t5, the internal pressure P of the chamber 17 was raised to a second set pressure P2 from the set pressure P1. The second set pressure P2 is 0.2 MPa. The second set pressure P2 was maintained between the fifth point in time t5 and the seventh point in time t7 during the solder cooling. In other words, at a sixth point in time t6 at which the temperature T of the solder was lowered than the melting temperature Tm, the internal pressure P of the chamber 17 was the second set pressure P2. When the solidification of the solder was completed at the seventh point in time t7, the internal pressure P of the chamber 17 was temporarily lowered to the normal pressure Po or less (vacuum). In other words, the reducing gas of the chamber 17 was discharged to the outside. The internal pressure P after the seventh point in time t7 in the second experimental example in which the internal pressure P of the chamber 17 was recovered to the normal pressure Po was the same as the first experimental example, by introducing the atmospheric air to the chamber 17 at an eighth point in time t8.

An X-ray photograph on the right side of the graph in Fig. 6B shows a back surface, that is, a joining surface of a soldered semiconductor element 12 in the second experimental example. In accordance with the X-ray photograph in Fig. 6B, neither unwet spots nor voids were observed in the entire solder layer H.

Fig. 7A shows a first comparative example in which the internal pressure P of the chamber 17 was set to the normal pressure Po or less at a time of heating and cooling the solder, just for reference. Fig. 7B shows a second comparative example in which the internal pressure P of the chamber 17 was set to the normal pressure Po or less at a time of cooling the solder.

As shown in Fig. 7A, the ambient atmosphere of the chamber 17 in the first comparative example was replaced by the reducing gas atmosphere before heating the solder from the second point in time t2. In other words, the internal pressure P of the chamber 17 was set to the set pressure P1 (0.13 MPa) at the first point in time t1.

However, as shown in Fig. 7A, the internal pressure P of the chamber 17 was lowered to the normal pressure Po or less at a point in time t23 existing between the second point in point in time t2 and the third point in time t3. In other words, the internal pressure P of the chamber 17 was maintained in a vacuum state between the point in time t23 and the eighth point in time t8.

In other words, the internal pressure P in the first comparative example was lowered to the normal pressure Po or less before the third point in time t3 at which the temperature T of the solder reached the melting temperature Tm at a time of heating the solder. The internal pressure P of the chamber 17 in accordance with the first comparative example was equal to or less than the normal pressure Po in both of a period between the second point in time t2 and the fourth point in time t4, which is the solder heating period, and a period between the fifth point in time t5 and the eighth point in time t8, which is the solder cooling period. The seventh point in time t7 does not exist in the graph in Fig. 7A. In other words, the seventh point in time t7 for maintaining the internal pressure P of the chamber 17 at the set pressure P1 after the sixth point in time t6 at which the solidification of the solder was completed does not exist in the graph in Fig. 7A.

An X-ray photograph on the right side of the graph in Fig. 7A shows the back surface, that is, the joining surface of a semiconductor element 12 soldered in the first comparative example. In accordance with the X-ray photograph, it was found out that voids were generated in all the solder layer H. Further, the voids were generated in a wide region. In other words, it was observed that voids were generated even in a state having a high degree of vacuum. The first comparative example strongly suggests that the gas hardly exists in voids.

In the second comparative example shown in Fig. 7B, the internal pressure P of the chamber 17 was the same as the first embodiment in Fig. 6A between the initial point in time t0 and the fifth point in time t5. In other words, the ambient atmosphere of the chamber 17 was replaced by the reducing gas atmosphere at the first point in time t1 before heating the solder. The internal pressure P of the chamber 17 was maintained at the set pressure P1 (0.13 MPa) between the second point in time t2 and the fifth point in time t5 at a time of heating the solder.

However, as shown in Fig. 7B, the internal pressure P of the chamber 17 was lowered to the normal pressure Po or lower at the fifth point in time t5. In other words, the internal pressure P of the chamber 17 was maintained at the normal pressure Po or lower (vacuum) between the fifth point in time t5 and the eighth point in time t8 corresponding to the solder cooling period. The seventh point in time t7 does not exist in the graph in Fig. 7B.

An X-ray photograph on thee right side of the graph in Fig. 7B shows the back surface, that is, the joining surface of ah semiconductor element 12 soldered in the second comparative example. In accordance with the X-ray photograph, the generating amount of the void was reduced in comparison with the first comparative example in Fig. 7A, and was improved. However, the void remains to be generated in all the solder layers H. The unwet spots were observed in a part of the solder layer H.

It is quite obvious that the first experimental example in Fig. 6A and the second experimental example in Fig. 6B inhibited the generation of voids in comparison with the first comparative example in Fig. 7A and the second comparative example in Fig. 7B. In the first experimental example and the second experimental example, the solder melting period t3 to t7 corresponds to a period until the solder was solidified at the seventh point in time t7 after the solder started melting at the third point in time t3. The molten solder was kept being pressurized in such a manner that the internal pressure P of the chamber 17 was maintained at the set pressure P1, which was higher than the normal pressure Po, in the solder melting period t3 to t7. The generation of voids was suppressed by pressurizing the molten solder as mentioned above.

The reducing gas having the higher pressure than the set pressure P1 (0.13 MPa) was fed from the hydrogen tank 23d in the solder melting period t3 to t7 of the first experimental example and the second experimental example. The pressure reducing valve 23c kept the internal pressure P of the chamber 17 at a fixed value, that is, the set pressure P1. The throttle valve 26c of the gas discharge portion 26 discharged a fixed amount of gas to the outside of the chamber 17. The reducing gas feeding portion 23 fed the reducing gas to the chamber 17 in such a manner as to compensate for a pressure reduction component of the internal pressure P of the chamber 17 caused by the gas discharge. As a result, the internal pressure P of the chamber 17 was kept at the fixed value. Further, the gas was circulated within the chamber 17. The internal pressure P of the chamber 17 in the solder melting period t3 to t7 was kept at a fixed value while taking into consideration a rising component of the internal pressure P of the chamber 17 caused by a temperature rising in the chamber 17 by heating the solder.

A consideration will be given to causes of the generation of voids on the basis of the results of experiments.

A surface tension of the molten solder is lowered as the temperature T of the solder rises. Since oxide exists on the surface of the solder, and the surface of the joined member (the semiconductor elements 12 and the wiring layers 15), a wettability of these surfaces is not good. Three kinds of materials including the solder, the joined member, and the atmospheric gas (the reducing gas in the present embodiment) cross in an interface in which the solder gets wet. On a cross line, or the line on which three kinds of materials cross, there exist a first surface tension applied between the joined member (solid body) and the atmospheric gas (gaseous body), a second surface tension applied between the molten solder (liquid body) and the atmospheric gas (gaseous body), and a boundary tension applied between the joined member (solid body) and the molten solder (liquid body). Each of the first surface tension, the second surface tension and the boundary tension is applied toward the corresponding interface direction from the cross line.

In many cases, the second surface tension between the molten solder and the atmospheric gas is great, and the boundary tension between the molten solder and the joined member has a negative value, immediately after the solder is molten. In this case, the solder is hard to be spread. The solder rather has a tendency to conglobate so that joined areas between the solder and the joined member are reduced. In order to suppress this tendency, it is effective to solder in a state in which the solder is pressurized by the weight 35 as in the present embodiment. For example, in a state in which a soft ball is sandwiched between a pair of upper and lower plates, the ball is collapsed by mounting a weight on the upper plate. Accordingly, the theory mentioned above is easy to understand. However, it is hard to prevent the conglobation tendency molten solder, only by the pressure of the ambient atmosphere. For example, even if the pressure of the atmospheric gas of a ball filled with water is raised, the ball is hard to be deformed from the spherical shape, however, the ball is easily collapsed by mounting a weight on the ball. Accordingly, the theory mentioned above is easy to understand.

As described in the background art of the present specification, the conventional void generation countermeasure heats the solder in the state in which the internal pressure P of the chamber 17 is set to the normal pressure Po or less (vacuum). This is based on the thinking that voids are generated by the atmospheric gas, or the gas generated from the residual gas, the solder or the like. In other words, it is thought that the generation of the void can be suppressed in the vented vacuum state.

However, as shown in Fig. 7A, the inventor of the present invention found out that voids are generated in solder even if soldering is carried out in the normal pressure Po or less (vacuum), on the basis of the experiments. In the case of joining the semiconductor element such as a power transistor of which one side is about 10 mm to the circuit board by the solder sheet, solder is dotted with voids. Many of the voids are of a cylindrical type passing through the solder having a thickness between 100 and 200 µm. In other words, the inventor of the present invention found out that voids were connected to both the surfaces of the joined portion. The fact that the solder existing between the semiconductor element and the circuit board before being heated disappears in the void portions through the heating means that the solder existing in the void portions was pushed away to the void peripheral portions by some force.

On the basis of these results, the inventor of the present invention considered that the inside of a void is in a low pressure state (a state having a high degree of vacuum), and the force generating voids is surface tension. The surface tension refers to a force minimizing the surface area of the liquid. The inventor of the present invention found out that a cylinder having a diameter of 1 mm, a height of 100 µm and a surface area 1 × n × 0.1 mm² is more stable than the case where a unwet portion having a diameter of 1 mm exists in a spherical state being close to a close contact without being joined, that is, the case where the spherical surface area is 0.025 × Π mm². Accordingly, if the inside of the void is in a state having a high degree of vacuum, it is considered that the void will disappears by applying a pressure overcoming the surface tension of the molten solder to the molten solder. In the case where soldering is carried out in the pressurized state as shown in Figs. 6A and 6B on the basis of the theory, it was possible to achieve a state in which no voids were observed, that is, a zero void state.

If the state of the void does not depend on presence or absence of gas, but depends on surface tension, the factors such as the material of the solder, the surface state of the semiconductor elements 12 and the wiring layers 15, the temperature T, the thickness of the solder and the like are expected to dominate the state of the void. In the case where the soldering was experimented under the same conditions by using the solder sheet 33 having a thickness of 100 µm and the solder sheet 33 having a thickness of 150 µm, a better result was obtained in the solder sheet 33 having a thickness of 150 µm.

For example, if two plates are dipped into a liquid body in a state in which a gap is formed between the plates, a liquid surface rises along the gap in the case that two plates are well wetted. The smaller the gap is, the higher the liquid surface rises. If the plate repels the liquid body due to poor wetting, the liquid surface is depressed. If the gap is small, the liquid surface is depressed. However, if the gap is large, the liquid surface is not significantly depressed.

The solder sheet 33 having a thickness of 100 µm corresponds to a case where the gap between a semiconductor element 12 and a wiring layer 15, which are two plates, is small. The solder sheet 33 having a thickness of 150 µm corresponds to a case where the gap between two plates is large. Accordingly, it is clear that the solder sheet 33 having a thickness of 150 µm suppresses voids on the basis of pressure more effectively than the solder sheet 33 having a thickness of 100 Mm. The inventor of the present invention believes that the generation of voids is suppressed by increasing the internal pressure P of the chamber 17.

The present embodiment has the following advantages.
(1) In the solder melting period t3 to t7 until the solder is solidified after starting melting, the soldering is carried out in the ambient atmosphere of the set pressure P1 equal to or higher than the normal pressure Po. Accordingly, the force overcoming the surface tension of the solder is applied to the molten solder. Therefore, it is possible to suppress the influence of the surface tension which is considered as the factor of the void generation, and it is possible to inhibit voids from being generated.
(2) In order to keep the internal pressure P of the chamber 17 at the fixed value, the reducing gas feeding portion 23 has the pressure reducing valve 23c. Accordingly, in the solder melting period t3 to t7, the stable pressurized state is achieved within the chamber 17, and it is possible to reliably inhibit voids from being generated. Particularly, in the case of solidifying the molten solder, the internal pressure P of the chamber 17 is lowered in accordance with the reduction of the temperature T within the chamber 17. It is possible to keep the internal pressure P of the chamber 17 at the normal pressure Po or higher by feeding the reducing gas to the chamber 17 from the pressure reducing valve 23c.
(3) The throttle valve 26c of the gas discharge portion 26 discharges the gas within the chamber 17 to the outside. Accordingly, the reducing gas is circulated between the inside and outside of the chamber 17. As a result, the water content within the chamber 17 generated by the reducing effect is removed by discharging the gas.
(4) As shown in Fig. 6B, in the second experimental example, the internal pressure P of the chamber 17 is raised further from the set pressure P1 at a time of finishing the solder heating. Accordingly, even if the void is generated in the molten solder, it is possible to eliminate voids until the molten solder is solidified. Accordingly, the generation of voids is easily suppressed.
(5) The weights 35 are heated by the high-frequency heating coils 28 which are away from the weights 35. Accordingly, in the case where a plurality of semiconductor elements 12 are soldered to the circuit board 11 all at once, it is not necessary to provide the high-frequency heating coil 28 per weight 35. In other words, the high-frequency heating coils 28, the number of which is less than the number of the weights 35, can heat a greater number of joined sections on the circuit board 11 all at once.
   Further, since the high-frequency heating coils 28 are away from the weights 35, it is possible to handle the high-frequency heating coils 28 independently from the weights 35 and the circuit board 11, at the time of cooling the molten solder. Accordingly, for example, in the case where a plurality of semiconductor modules 100 are arranged within the chamber 17, it is possible to improve the operating efficiency of the high-frequency heating coils 28 by moving the high-frequency heating coils 28 from a certain semiconductor module 100 to another semiconductor module 100.
   Further, the present embodiment heats the joined section of the circuit board 11 by heating the weights 35 pressing the semiconductor elements 12. Accordingly, it is possible to concentrically transmit the heat to the joined section. Therefore, it is possible to improve the heating efficiency, for example, in comparison with the case of heating the entire circuit board 11 or the entire chamber 17.
(6) One high-frequency heating coil 28 is arranged above a plurality of weights 35 on one circuit board 11. Accordingly, it is possible to two-dimensionally transmit heat to a plurality of joined sections in one circuit board 11. Therefore, it is possible to uniformly heat a plurality of joined sections. As a result, it is possible to approximate the melting start timings of the solder sheets 33 arranged at the respective joined sections in such a manner as to be substantially simultaneous. Further, it is possible to approximate the timings at which all the solder sheets 33 finish melting in such a manner as to be substantially simultaneous. Therefore, it is possible to make the soldering work efficient.
(7) The high-frequency heating coils 28 are arranged outside of the chamber 17. Accordingly, the high-frequency heating coils 28 do not need to be held in positions in the soldering work except for the heating period. In other words, the high-frequency heating coils 28 can be detached from the chamber 17 except for the heating period. Therefore, it is possible to improve the production efficiency of the semiconductor modules 100 by moving one high-frequency heating coil 28 to other chambers 17 one after the other.
   Further, a volumetric capacity of the chamber 17 in accordance with the present embodiment, in which the high-frequency heating coils 28 are arranged outside of the chamber 17, is smaller than, for example, the case where a heating members, that is, the high-frequency heating coils 28 are arranged within the chamber 17. Accordingly, it is possible to achieve a downsizing of the chamber 17.
   The regulation of the ambient atmosphere mainly includes discharging the air from the chamber 17, that is, vacuuming, and feeding and discharging the inert gas such as nitrogen gas or the like and reducing gas such as hydrogen gas or the like. Accordingly, it is possible to reduce the time and the energy consumption necessary for discharging the air by reducing the volumetric capacity of the chamber 17. For example, it is possible to reduce the operating energy of the vacuum pump 25c. Further, it is possible to reduce the time and the energy consumption necessary for feeding or discharging inert gas or reducing gas to and from the chamber 17. It is also possible to reduce the consumption of inert gas and reducing gas.
(8) The lid 19, which is a portion of the chamber 17 that faces the high-frequency heating coils 28, is formed by the glass plate 22, which is an electrically insulating material. Accordingly, it is possible to prevent the chamber 17 from generating heat. Further, since the magnetic flux passes through the chamber 17, it is possible to heat the weights 35.
(9) One pressing surface 35a of the weight 35 can come into contact with the non-joining surfaces 12a of a plurality of semiconductor elements 12. In other words, one weight 35 corresponds to an assembly obtained by collecting a plurality of sub weights each of which is provided for pressing one semiconductor element 12. Accordingly, it is possible to enlarge the pressing surface 35a of one weight 35. Therefore, in comparison with the case where the pressing surface 35a is small, the weights 35 stably press each of the semiconductor elements 12. Accordingly, each of the semiconductor elements 12 is hardly affected by the surface tension of the molten solder, and the soldering work is stably carried out.
(10) One high-frequency heating coil 28 is allocated to one circuit board 11. Accordingly, the heat generating efficiency of the weights 35 is higher than the case where one high-frequency heating coil 28 is allocated to a plurality of circuit boards 11.

The embodiment mentioned above may be modified as follows.

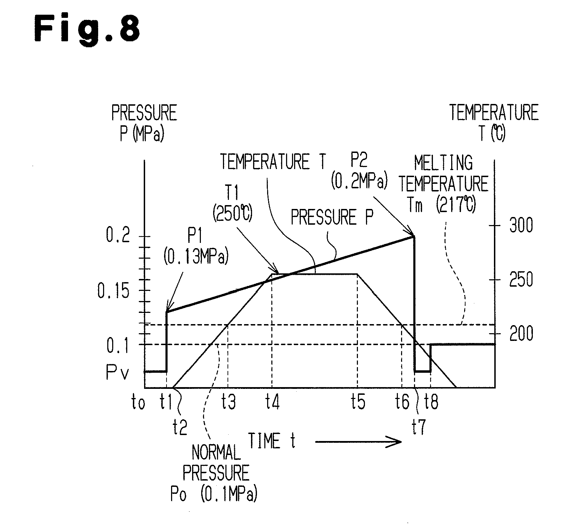

As shown in Fig. 8, the internal pressure P of the chamber 17 may be gradually increased in the solder melting period t3 to t7. In other words, the internal pressure P of the chamber 17 is gradually increased from the set pressure P1 at the second point in time t2 toward the second set pressure P2 at the seventh point in time t7. In other words, the internal pressure P of the chamber 17 in the solder melting period t3 to t7 is not limited to be kept at the set pressure P1 or the second set pressure P2, which is a fixed value.

The set pressure P1 may be set higher than 0.13 MPa. The second set pressure P2 may be changed from 0.2 MPa. The set pressure P1 and the second set pressure P2 are set taking the durability of the chamber 17 into consideration.

The set pressure P1 is not limited to 0.13 MPa. In correspondence to the materials of the wiring layer 15 and the semiconductor elements 12 and the condition of the surface treatment, the set pressure P1 may be set to a range between 0.11 MPa and 0.13 MPa, inclusive. The closer to the normal pressure Po outside of the chamber 17, the more advantageous the internal pressure P of the chamber 17 in terms of the durability of the chamber 17. Further, the set pressure P1 can be changed in correspondence to the wettability and the surface tension of the molten solder. The inert gas has been conventionally fed to a reflow furnace used for soldering, for preventing the atmospheric air from making an intrusion into the reflow furnace. However, the feed of the inert gas only sets the internal pressure of the reflow furnace to about the normal pressure.

The internal pressure P of the chamber 17 in the solder melting period t3 to t7 may be kept at the set pressure P1, which is a fixed value, by introducing the reducing gas having a higher pressure than the set pressure P1 to the chamber 17 on the basis of the pressure value obtained by monitoring the internal pressure P of the chamber 17. Alternatively, the internal pressure P of the chamber 17 may be gradually increased by feeding the reducing gas.

In the embodiment mentioned above, a throttle valve may be connected to the reducing gas feeding portion 23. The internal pressure P of the chamber 17 may be gradually increased by feeding the reducing gas to the chamber 17 by the throttle valve.

In the embodiment mentioned above, the gas atmosphere of the chamber 17 at the time of heating or cooling the solder is the reducing atmosphere having 100% hydrogen. This may be changed, for example, to a mixed gas atmosphere in which hydrogen gas, that is, reducing gas is set to 3%, and the remainder is nitrogen gas, that is, inert gas.

The reducing gas is not limited to hydrogen gas, but may be, for example, gas of which the composition includes formaldehyde.

The heating system of the solder is not limited to the high-frequency induction heating by the high-frequency heating coils 28, but may be structured, for example, such that a heating device is provided within the chamber 17. Further, a heat transfer medium may be circulated in the heat sink 13. The heat sink 13 may heat the solder by transferring the heat to the solder sheet 33.

The soldering apparatus HK may be provided with an ambient atmosphere regulating device regulating an internal atmosphere of the chamber 17. The ambient atmosphere regulating device is connected to each of the on-off valves 23b, 24b, 25b and 26b and the vacuum pump 25c. The ambient atmosphere regulating device controls the reducing gas feeding portion 23, the inert gas feeding portion 24, the vacuum portion 25 and the gas discharge portion 26. As a result, it is possible to feed reducing gas and inert gas to the chamber 17, and it is possible to discharge gas and air from the chamber 17.

The joined object 93, to which the semiconductor elements 12 are soldered, may be a circuit board 11 to which no heat sink 13 is joined. In this case, the semiconductor device including the circuit board 11 and the semiconductor elements 12 is manufactured in the chamber 17. The number of the circuit boards 11 included in the semiconductor module 100 is not limited to six, but may be changed.

The lid 19 may be detachably mounted to the box main body 18, or may be structured as an opening and closing type.

The portion facing the high-frequency heating coil 28 in the lid 19 may be formed by an electrically insulating material other than glass, for example, ceramics or resin. In order to ensure that the lid 19 has a strength that stands against the atmospheric pressure difference between the inside and the outside of the chamber 17, it is preferable that the lid 19 be structured by a compound material, for example, of glass fiber and resin, that is, a glass fiber reinforced plastic (GFRP). Further, the lid 19 may be formed by a nonmagnetic metal. In the case where the lid 19 is formed by magnetic metal, it is preferable to employ a material having a higher electric resistivity than the weights 35. The lid 19 may be structured by a compound material of metal and insulating material. It is preferable to arrange an electromagnetic steel plate of a ferromagnetic material in a portion immediately above the weight in order to effectively introduce magnetic flux to the weights 35.

The weights 35 are not limited to integrated parts each formed by machining a material. Each weight 35 may be one assembly formed by joining a plurality of divided bodies.

In place of the weights 35, a plurality of sub weights each corresponding to one semiconductor element 12 may be employed. Specifically, four sub weights are prepared in correspondence to four semiconductor elements 12 joined to one circuit board 11. Each of the sub weights is arranged immediately above the corresponding semiconductor element 12.

The component of the solder sheet 33 is not limited to the embodiment mentioned above. In order to inhibit voids from being generated, it is preferable to pressurize the molten solder, that is, the solder in the molten state, and the component of the solder sheet 33 is not limited.

In the embodiment mentioned above, the reducing gas feeding portion 23 connected to the gas inlet of the chamber 17 has the pressure reducing valve 23c. The gas discharge portion 26 connected to the outlet of the chamber 17 has the throttle valve 26c. However, the layout of the pressure reducing valve and the throttle valve may be changed. For example, the reducing gas feeding portion 23 may have the pressure reducing valve 23c and a throttle valve, and the gas discharge portion 26 may also have a pressure reducing valve and the throttle valve 26c. Inversely to the embodiment mentioned above, the reducing gas feeding portion 23 may have only a throttle valve, and the gas discharge portion 26 may have only a pressure reducing valve. Only the reducing gas feeding portion 23 may have one of the pressure reducing valve and the throttle valve.

In this case, the pressure reducing valve can keep the internal pressure P of the chamber 17 constant. In the case where the throttle valve 26c is provided without the provision of the pressure reducing valve 23c, it is possible to gradually increase the internal pressure P of the chamber 17 by setting the flow rate of the gas fed to the chamber 17 higher than the flow rate of the gas discharged from the chamber 17. The pressure regulating portion connected to the inlet of the chamber 17 serves as the first pressure regulating portion. The pressure regulating portion connected to the outlet of the chamber 17 serves as the second pressure regulating portion.

## Claims

1. A soldering method of soldering a semiconductor element (12) to a circuit board (11), the soldering method comprising:
accommodating an object-to-be-soldered (92) in a chamber (17), the object-to-be-soldered (92) including the circuit board (11), the semiconductor element (12), and solder (33) arranged between the circuit board (11) and the semiconductor element (12), and the solder (33) having a melting temperature (Tm);
achieving a reduction state in which the chamber (17) is filled with an atmospheric gas at least including a reducing gas (t1);
melting the solder (33) by heating the solder (33) in such a manner as to raise a temperature (T) of the solder (33) to a temperature equal to or higher than the melting temperature (Tm), in the chamber (17) in the reduction state (t3 to t5); and
soldering the semiconductor element (12) to the circuit board (11) by solidifying the solder (33) by lowering the temperature (T) of the molten solder (33) to the melting temperature (Tm) or lower (t6 to t7),
wherein the soldering method is **characterized by:**
structuring the chamber (17) to be sealable;
raising an internal pressure (P) of the chamber (17) to a melting start pressure (P1), which is equal to or higher than a normal pressure (Po), by the atmospheric gas until the temperature (T) of the solder (33) reaches the melting temperature (Tm)(t3), the melting start pressure (P1) being the internal pressure (P) of the chamber (17) at a time when the solder (33) starts melting;
achieving a pressurization state in which the internal pressure (P) of the chamber (17) is set to be equal to or higher than the melting start pressure (P1), in a solder melting period (t3 to t7), the solder melting period (t3 to t7) being a period (t7) until the molten solder (33) is solidified (t7) after the solder (33) starts melting (t3); and
soldering the semiconductor element (12) to the circuit board (11) in the pressurization state.

2. The soldering method according to claim 1, **characterized in that** the melting start pressure (P1) is equal to or higher than 0.11 MPa.

3. The soldering method according to claim 1, **characterized in that** the melting start pressure (P1) is equal to or higher than 0.13 MPa.

4. The soldering method according to claim 1, **characterized in that** the melting start pressure (P1) is within a range between 0.11 MPa and 0.13 MPa, inclusive.

5. The soldering method according to any one of claims 1 to 4, **characterized by:**
setting the atmospheric gas having a pressure higher than the melting start pressure (P1) to a fixed value by a first pressure regulating portion (23c), in the solder melting period (t3 to t7); and
keeping the internal pressure (P) of the chamber (17) constant or gradually increasing the internal pressure (P) of the chamber (17) by introducing the atmospheric gas set to the fixed value to the chamber (17).

6. The soldering method according to any one of claims 1 to 4, **characterized by:**
monitoring the internal pressure (P) of the chamber (17) in the solder melting period (t3 to t7); and
keeping the internal pressure (P) of the chamber (17) constant or gradually increasing the internal pressure (P) of the chamber (17) by introducing the atmospheric gas having a pressure higher than the melting start pressure (P1) to the chamber (17), on the basis of a pressure value obtained by the monitoring.

7. The soldering method according to claim 5 or 6, **characterized by:**
circulating the atmospheric gas within the chamber (17) in the solder melting period (t3 to t7) by discharging the atmospheric gas introduced to the chamber (17) to the outside of the chamber (17) by a second pressure regulating portion (26c).

8. The soldering method according to any one of claims 1 to 7, **characterized by:**
arranging a pressing body (35), which presses the semiconductor element (12) toward the circuit board (11), immediately above the semiconductor element (12).

9. The soldering method according to any one of claims 1 to 8, **characterized by:**
setting, in the solder melting period (t3 to t7), an internal pressure (P2) of the chamber (17) to a pressure higher than the pressure (P1) at the time when the heating of the solder (33) is completed, until the solder (33) is solidified (t7) after the heating of the solder (33) is finished (t5).

10. A manufacturing method of a semiconductor device (100), the semiconductor device (100) including a circuit board (11) and a semiconductor element (12) soldered to the circuit board (11), the manufacturing method of the semiconductor device (100) comprising:
preparing a sealable chamber (17);
accommodating an object-to-be-soldered (92) in the chamber (17), the object-to-be-soldered (92) including the circuit board (11), the semiconductor element (12), and solder (33) arranged between the circuit board (11) and the semiconductor element (12), and the solder (33) having a melting temperature (Tm);
achieving a reduction state in which the chamber (17) is filled with an atmospheric gas at least including a reducing gas (t1);
melting the solder (33) by heating the solder (33) in such a manner as to raise a temperature (T) of the solder (33) to a temperature equal to or higher than the melting temperature (Tm), in the chamber (17) in the reduction state (t3 to t5); and
soldering the semiconductor element (12) to the circuit board (11) by solidifying the solder (33) by lowering the temperature (T) of the molten solder (33) to the melting temperature (Tm) or lower (t6 to t7),
wherein the manufacturing method is **characterized by:**
raising an internal pressure (P) of the chamber (17) to a melting start pressure (P1) equal to or higher than a normal pressure (Po) by the atmospheric gas until the rising temperature (T) of the solder (33) reaches the melting temperature (Tm), the melting start pressure (P1) correspond being the internal pressure (P) of the chamber (17) at a time when the solder (33) starts melting;
achieving a pressurization state in which the internal pressure (P) of the chamber (17) is set to be equal to or higher than the melting start pressure (P1), in a solder melting period (t3 to t7), the solder melting period (t3 to t7) being a period until the molten solder (33) is solidified (t7) after the solder (33) starts melting (t3); and
soldering the semiconductor element (12) to the circuit board (11) in the pressurization state.

11. A soldering apparatus (HK) for soldering a semiconductor element (12) to a circuit board (11), the soldering apparatus (HK) comprising:
a sealable chamber (17);
a heating apparatus (28) heating solder (33) arranged between the circuit board (11) and the semiconductor element (12) so as to melt the solder (33), the circuit board (11), the semiconductor element (12) and the solder (33) constructing an object-to-be-soldered (92), and the solder (33) having a melting temperature (Tm); and
a gas introduction portion (23) introducing an atmospheric gas at least including a reducing gas to the chamber (17), the gas introduction portion (23) introducing the atmospheric gas to the chamber (17) in a state in which the object-to-be-soldered (92) is accommodated, the heating apparatus (28) raising a temperature (T) of the solder (33) in a state in which the atmospheric gas is introduced to the melting temperature (Tm) or higher so as to melt the solder (33), and the gas introduction portion (23) raising an internal pressure (P) of the chamber (17) to a melting start pressure (P1) equal to or higher than the normal pressure (Po) by the atmospheric gas, until the temperature (T) of the solder (33) reaches the melting temperature (Tm),
wherein the soldering apparatus (HK) is **characterized by** being structured such as to achieve a pressurization state in which the internal pressure (P) of the chamber (17) is set to a pressure equal to or higher than the melting start pressure (P1), in a solder melting period (t3 to t7) until the molten solder (33) is solidified after the solder (33) starts melting, and solder the semiconductor element (12) to the circuit board (11) in the pressurization state.
